# EUROPEAN PATENT APPLICATION

(11) **EP 4 832 046 A1**
(43) Date of publication of application: **28.10.2026**
(21) Application number: 25382409.8
(22) Date of filing: 23.04.2025
(51) Int. Cl.: H01J 37/22, H01J 37/244, G01N 23/02, H01J 37/26

(54) **SPECTROMETER-FREE ELECTRON SPECTROMICROSCOPY**

(71) Applicant: Fundació Institut de Ciències Fotòniques, 08860 Castelldefels (Barcelona) (ES); Institució Catalana De Recerca I Estudis Avançats (ICREA), 08010 Barcelona (ES)
(72) Inventor: Garcia de Abajo, Javier, 08860 Castelldefels (Barcelona) (ES)
(74) Representative: Grünecker Patent- und Rechtsanwälte PartG mbB

(57) **Abstract**

A system for spectrally resolved electron microscopy, comprising an electron source configured to provide an incident electron beam; a pair of diffraction elements, including a first diffraction element and a second diffraction element, each diffraction element suitable for diffracting electron beams; a pair of electron-focusing elements including a first electron-focusing element with a focal length of f₁, and a second electron-focusing element with a focal length of *f*₂; a light source configured to provide pulsed or continuous wave coherent or partially coherent light in order to illuminate a specimen to be studied positioned between the first electron focusing element and the second electron focusing element; an electron detector; wherein the first diffraction element is configured to split the electron beam received from the electron source into a plurality of electron beams; wherein the first electron focusing element is configured to focus the electron beams transmitted by the first diffraction element onto a focal plane; wherein the second electron focusing element is configured to transform the electron beams transmitted by the first electron-focusing element and having passed the focal plane into one plane wave each, respectively; wherein the second diffraction element is configured to diffract the plane wave received from the second electron-focusing element onto the electron detector; wherein the light source is configured to vary the frequency of the pulsed or continuous-wave coherent or partially coherent light, and the electron detector is configured to measure the current of the electron beams received from the second diffraction element and to collect spectra formed by the measured current as a function of the varied frequency of the pulsed or continuous-wave and at least partially coherent light.

## Description

### Field of Invention

The present invention relates to a system and corresponding method for performing spectrally resolved electron microscopy without needing an electron spectrometer.

### Background of the invention

Since the invention of the electron microscope nearly a century ago [1], a sustained series of technical advances have permitted the generation of electron beams, also denoted as e-beams, with a high degree of lateral coherence and small energy broadening [2]. State-of-the-art instruments allow electron energy-loss spectroscopy (EELS) to be performed with a combined spatiotemporal resolution in the sub-ångström and few-meV regime [3]. Examples of application are the study of vibrational features with atomic detail, the characterization of narrow excitons in transition-metal dichalcogenides, and the identification of photonic modes in dielectric cavities. However, EELS is still unable to resolve fine spectral structures in high-quality-factor optical excitations of interest for nanophotonics, such as long-lived excitons and narrow resonances in dielectric cavities, which are highly dependent on the nanostructured material environment [4].

Electron energy-gain spectroscopy (EEGS) has emerged as a unique technique capable of reaching a spectral resolution in the µeV range by recording the fraction of electrons whose energy is increased when traversing a laser-irradiated specimen [5,6]. In EEGS, the electron interacts with the scattered optical field, which can contain evanescent components with sufficient momentum to break the kinematic mismatch between electrons and photons in free space, thus producing inelastic electron-light scattering (IELS). The probability that electrons absorb photons is proportional to the near-field intensity, which is boosted when the laser frequency matches optical resonances in the specimen. Consequently, even with a modest electron energy resolution in the sub-eV range, a high spectral resolution can be achieved by fine-tuning the photon energy [6].

Soon after EEGS was proposed [5], a temporal resolution in the femtosecond domain was demonstrated in electron microscopy through the synthesis of synchronized femtosecond electron and laser pulses in the so-called photon-induced near-field electron microscopy (PINEM) technique [7-10]. Early attempts to perform EEGS based on PINEM [11] produced an energy resolution similar to EELS and limited by the short duration of the electron pulses due to the uncertainty principle. To push energy resolution to the sub- or few-µeV range, continuous-wave lasers were necessary [6].

The techniques mentioned above require electron spectrometers and monochromators. For example, in EEGS and PINEM, electron spectra need to be collected with better resolution than the employed photon energy. The ability to collect spatially resolved spectral information on a specimen without using an electron spectrometer could simultaneously eliminate the need for electron monochromators and make the acquisition of spectral information in electron microscopes more widely available.

In view of the above, it is an object of the present invention to alleviate the above-mentioned problems by providing a system and corresponding method for performing spectrally resolved electron microscopy without needing an electron spectrometer.

### Summary

The present invention addresses the above-mentioned problems by providing the following:
A system for spectrally resolved electron microscopy, comprising an electron source configured to provide an incident electron beam; a pair of diffraction elements, including a first diffraction element and a second diffraction element, each diffraction element suitable for diffracting electron beams; a pair of electron-focusing elements including a first electron-focusing element with a focal length of f₁, and a second electron-focusing element with a focal length of *f*₂;a light source configured to provide pulsed or continuous wave coherent or partially coherent light in order to illuminate a specimen to be studied positioned between the first electron focusing element and the second electron focusing element; an electron detector; wherein the first diffraction element is configured to split the electron beam received from the electron source into a plurality of electron beams; wherein the first electron focusing element is configured to focus the electron beams transmitted by the first diffraction element onto a focal plane; wherein the second electron focusing element is configured to transform the electron beams transmitted by the first electron-focusing element and having passed the focal plane into one plane wave each, respectively; wherein the second diffraction element is configured to diffract the plane wave received from the second electron-focusing element onto the electron detector; wherein the light source is configured to vary the frequency of the pulsed or continuous-wave coherent or partially coherent light, and the electron detector is configured to measure the current of the electron beams received from the second diffraction element and to collect spectra formed by the measured current as a function of the varied frequency of the pulsed or continuous-wave and at least partially coherent light.

Thus, the electron detector is configured to collect, i.e., measure, spectra through the measured current of electrons transmitted through the system as a function of the varied frequency of the pulsed coherent or partially coherent light, thus providing spectral information on the optical response of a specimen with spatial precision determined by the lateral width of the focused electron beam at the focal plane.

It should be understood that when a laser is used as a light source, the light will be fully coherent. It should further be understood that using pulsed light from the light source may yield an increased light intensity; however, continuous-wave light would work, as well.

It should be understood that while the term "specimen" is used here, this term should be considered as being synonymous with the term "sample".

It should be understood that when a specimen is positioned into the system, it may be positioned in the region between the first and second focusing elements. In particular, it may be positioned at the focal plane.

In the system according to the first aspect, the second diffractive element may be laterally adjustable with respect to the first diffractive element.

In the system according to the first aspect, the first diffraction element and the second diffraction element are laterally positioned complementary to each other such that in absence of the specimen electron beams transmitted by the first diffraction element and having passed the first focusing element and the second focusing element are blocked by the second diffraction element.

The system according to the first aspect may further comprise: the first diffractive element is a first electron grating with a period of a₁, and a second diffractive element is a second electron grating with a period of *a*₂, where the periods *a*₁, *a*₂ and the focal lengths *f*₁ and *f*₂ fulfil the condition $\frac{{a}_{1}}{{a}_{2}} = \frac{{f}_{1}}{{f}_{2}} .$

The system according to the first aspect may further comprise: the first diffractive element and the second diffractive element represent conjugated electron masks configured to prepare beams with predefined transverse symmetries, such as vortices.

The system according to the first aspect may further comprise: a distance between the first electron focusing element and the focal plane is equal to the distance between the first diffractive element and the first electron focusing element, and a distance between the second electron focusing element and the focal plane is equal to the distance between the second diffractive element and the second electron focusing element.

In the system according to the first aspect, the electron detector may be configured to collect all diffracted beams received from the second diffractive element.

In the system according to the first aspect, the first diffractive element, the first electron focusing element, the second electron focusing element and the second diffractive element may be arranged such that the first diffractive element is imaged onto the second diffractive element and vice versa.

With this condition, each grating or each diffractive element will lie in the image plane of the other grating or diffractive element, respectively.

In the system according to the first aspect, the electron detector may be configured to provide angle-resolved electron detection.

The system according to the first aspect may further comprise: the first and the second diffractive elements are symmetric diffractive elements and are configured to transmit only the first two diffraction orders of the electron beam incident on the respective diffractive element, wherein the second diffractive element is configured to recombine different electron beams that were focused in the focal plane.

The system according to the first aspect may be configured to raster scan the central beam of the electron beam emitted by the second diffractive element and to tune the light source to dipole active modes, in order to map the specimen.

The system according to the first aspect may further comprise: when the specimen is positioned between the first electron focusing element and the second electron focusing element and is illuminated by the light source, the system is configured to detect interaction of one or more of the focused beams transmitted by the first diffractive element with the illuminated specimen; and when no specimen is positioned in the system, the electron detector is configured to detect a partial or complete depletion of the electron beam transmitted by the second diffractive element.

The present invention further provides: a second aspect of a method for performing spectrally resolved electron microscopy with a system according to the first aspect, the method comprising: providing, by the electron source, an incident e-beam; splitting, by the first diffraction element, the electron beam received from the electron source into a plurality of electron beams; focusing, by the first electron focusing element, the plurality of electron beams split by the first diffraction element, onto a focal plane; transforming, by the second electron focusing element, the electron beams transmitted by the first electron-focusing element and having passed the focal plane into a plane wave, respectively; diffracting, by the second diffraction element, the plane wave received from the second electron focusing element onto the electron detector; measuring, by the electron detector, the current of: either each of the individual electron beams received from the second diffraction element by using angular resolution in the electron detector or all of the electron beams received from the second diffraction element by using an angle-integrated electron detector; and when the specimen to be studied is positioned between the first electron focusing element and the second electron focusing element, varying the frequency of the pulsed or continuous-wave coherent or partially coherent light emitted by the light source to illuminate the specimen, and collecting, by the electron detector, the measured current of electron beams as a function of the varied frequency of the pulsed or continuous-wave coherent or partially coherent light.

The method according to the second aspect, wherein the method may further comprise: laterally adjusting the first diffraction element and the second diffraction element complementary to each other such that in absence of the specimen electron beams transmitted by the first diffraction element and having passed the first focusing element and the second focusing element are blocked by the second diffraction element.

### Brief description of the drawings

- FIG. 1:: illustrates a system for spectrally resolved electron microscopy according to an embodiment of the present disclosure;
- FIG. 2:: illustrates an interference pattern related to the system of the embodiment of FIG. 1;
- FIG. 3:: illustrates an example of an SFES spectrum measured with the system of the embodiment of FIG. 1;
- FIG 4: illustrates a system for spectrally resolved electron microscopy according to a further embodiment of the present disclosure;
- FIG. 5:: illustrates SFES mapping of localized optical excitations related to the system of the embodiment of FIG. 4;
- FIG. 6: illustrates a mapping of SFES as a function of e-beam position when a probe / specimen is illuminated, according to the system of the embodiment of FIG. 4.
- FIG. 7: illustrates a method for performing spectrally resolved electron microscopy with a system according to the embodiment of FIG. 4 or of FIG. 1.

### Description

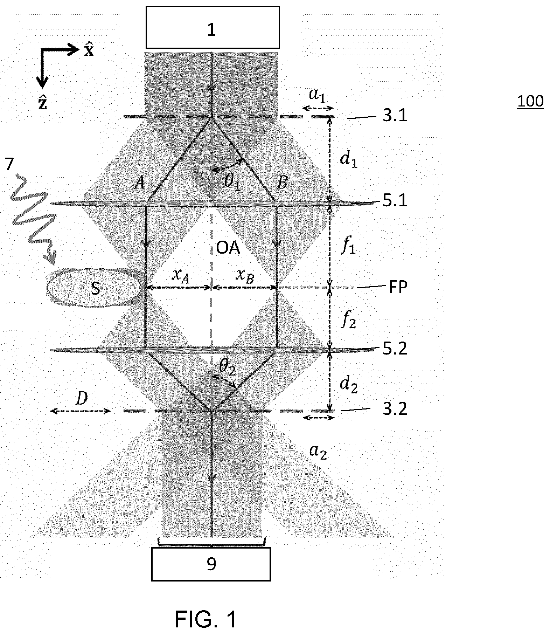

The principle of spectrometer-free electron spectromicroscopy (SFES) is schematically depicted in FIG. 1: an electron plane wave is split into two beams, *A* and *B,* that are focused in the plane of a specimen and later recombined into a single e-beam, where they interfere; the visibility of the interference pattern constitutes the measured signal; the specimen is illuminated by a laser that produces IELS analogous to PINEM on the electron path *A* passing closest to it; the interference signal is thus depleted, i.e., in proportion to the optical near-field intensity, by subtracting electrons from the elastic channel in path *A*, while path B remains nearly elastic because it passes away from the specimen. We present a detailed analysis of the signal expected under attainable conditions, along with an extension to multiple-path splitting that should facilitate the implementation of SFES by eliminating the need for angular resolution, i.e., all transmitted electrons are detected.

FIG. 1 illustrates a system for spectrally resolved electron microscopy according to an embodiment of the present disclosure. FIG. 1 illustrates the basic principle of SFES. In the system 100 of FIG. 1, an incident e-beam is prepared by an electron source 1. The electron source 1 may be one of a thermal electron source, a photoelectric source, a cold-emission source, or any other free-electron source. Further, a combination of electron sources is also conceivable. The production / preparation of an e-beam is well understood and is not mentioned here. The electron beam is provided, e.g., as an on-axis electron plane wave, which is diffracted by a periodic diffractive element, for example a grating, element 3.1. The diffraction element 3.1 has a period *a*₁ along **x̂**, where **x̂** is one of the three unit vectors for Cartesian coordinates. We consider two dominant diffracted beams, i.e., paths *n = A, B,* forming an angle *θ*₁ relative to the optical axis **ẑ**. An electron-focusing element, for example a lens, element 5.1 having a focal length *f*₁ focuses these beams on the sample plane at lateral positions **R**ₙ = *xₙ***x̂**. The distance between the first diffraction element 3.1 and the first electron focusing element 5.1 is given by *d*₁*.*

A second electron focusing element, for example a lens, lens 5.2 having a focal length *f*₂, transforms each beam n into a plane wave that is in turn diffracted by a second diffraction element, for example a grating, element 3.2 having a period *a*₂, and a lateral displacement *D* along **x̂** with respect to the first grating. The distance between the second diffraction element 3.2 and the first electron focusing element 5.2 is given by *d*₂*.*

Here, it should be understood that all elements of the system are provided substantially perpendicular to the optical axis OA of the system, although a configuration based on off-axis beams is also possible and may be described by the same equations here elaborated.

Path *A* may be closest to the specimen and interacts with the optical field scattered from the specimen, which is illuminated by a laser of frequency *ω.*

FIG. 1 further shows, schematically, an electron detector, element 9. The electron detector 9 is configured to measure the incident electrons, e.g., the current of incident electrons, i.e., electron incident upon the detector once they have traversed the elements above it. It should be understood that the electron detector 9 may include one or more processors, e.g., computing elements for analyzing the measured data. In addition or alternatively, the electron detector 9 may be coupled with an external computer or the like for data analysis. Such analysis elements are well understood and are not further detailed here.

FIG. 1 further indicates a light source 7. The light source 7 may produce at least partially coherent light. The light source 7 may also be a laser producing fully coherent light. The light source 7 may be used to illuminate a specimen S which is introduced into the system. Thus, it is clear that the system may be used with or without a specimen S. Further, the specimen S may be positioned in the region between the first focusing element and the second focusing element. For simplicity, the specimen S may be positioned in the focal plane.

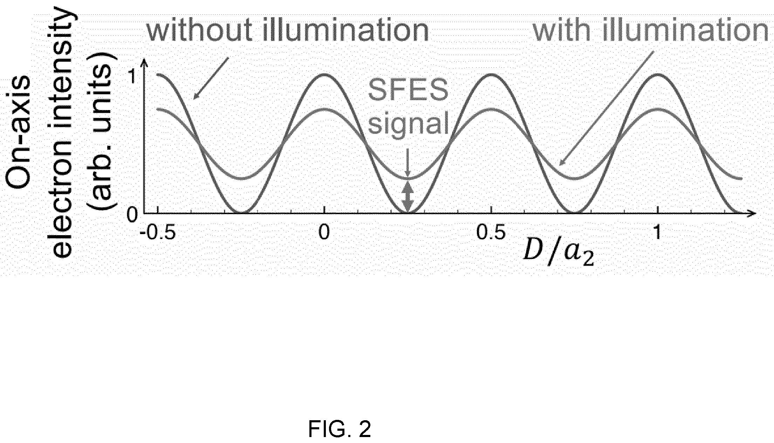

In FIG. 2, an interference pattern relating to the system of FIG. 1 is shown. The interference pattern is formed as a function of *D,* whose visibility is modulated by IELS via the depletion of the elastic channel depending on the optical near-field intensity. In other words, FIG. 2 illustrates two scenarios, one showing the response when a specimen is introduced and illuminated and one where the specimen is not illuminated / introduced into the system. In that case, the curves, e.g., the minima, basically fully deplete the electron transmission as is shown in FIG. 2.

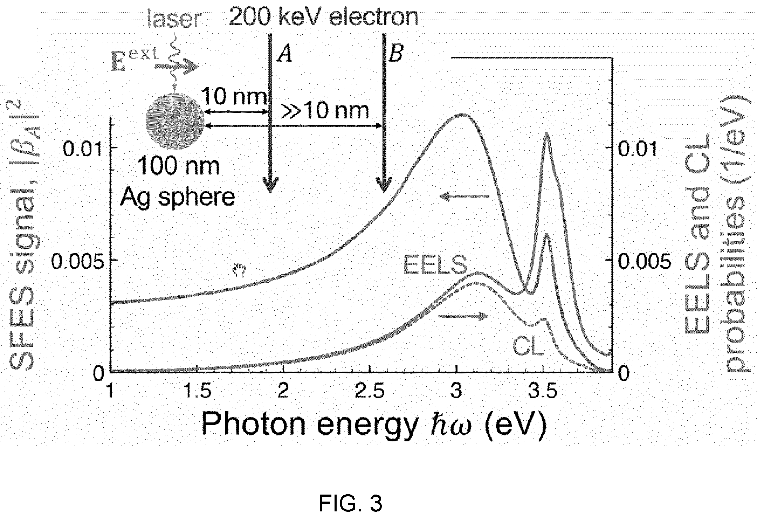

FIG. 3 illustrates an example of an SFES spectrum measured with the system of FIG. 1. In FIG. 3, the *ω*-dependent interference visibility yields an SFES spectrum, i.e., left scale, assuming an external field *E*^{ext} = 2 MV/m, i.e., right scale, for a single beam along path *A*, here presented for the geometry and specimen S of FIG. 1.

The incident two-path electron state considered in FIG. 1 can be written as $\left|{Ψ}^{inc}\right〉 = \left(\left|A\right〉+\left|B\right|\right) ⊗ \left|0\right〉$ before interaction with the specimen, where |*A*〉 and |*B*〉 denote the mutually orthogonal transverse part, i.e., along *x - y* directions, associated with the respective paths, while |*O*〉 refers to the initial longitudinal component, i.e., along *z.* Following a well-established theoretical description of PINEM [12], the electron state after interaction with the illuminated specimen can be written as $\left|Ψ\right〉 = {\sum }_{l} \left({α}_{A , l}\left|A\right〉+{α}_{B , l}\left|B\right〉\right) ⊗ \left|l\right〉 ,$ (1a) where |ℓ〉 is the longitudinal electron component after exchanging ℓ photons with the optical field, while the corresponding IELS amplitudes ${α}_{n , l} = {J}_{l} \left(2\left|{β}_{n}\right|\right) {e}^{i l arg \left\{-{β}_{n}\right\}}$ (1b) depend on the coupling coefficients ${β}_{n} = \left(e/ℏω\right) \int {dzE}_{z} \left({R}_{n}, z\right) {e}^{- \frac{i ωz}{v}}$ (1c) **determined** by the spatial Fourier transform of the *z* component of the optical electric field **E**(*r*) evaluated along the paths *n* = *A* and *B* passing through the focal points **R***ₙ* at the sample plane. Here, we consider a monochromatic and coherent optical field **E**(**r**, *t*) = **E**(**r**)e^{-i*ωt*} + c. c. of frequency *ω*, which varies negligibly over the width of the focused e-beams. In addition, the transverse electron state is assumed to be unaffected by the interaction under the nonrecoil approximation [12].

For illustrative purposes, in FIG. 1, we consider symmetric gratings, e.g., elements 3.1 and 3.2, transmitting only the two first diffraction orders, which correspond to in-plane wave vector transfers ±2*π*/*aᵢ,* where + and - refer to paths *n* = *A* and *B,* while *i =* 1, 2 denotes the grating index. Furthermore, we draw *fᵢ* = *dᵢ* for clarity, but this condition is neither required nor assumed in what follows. The paraxial angles *θᵢ* after and before diffraction by gratings 1 and 2, respectively, must be coordinated so that an on-axis beam component is obtained after the entire process. This condition is fulfilled by imposing the relation $\frac{{a}_{1}}{{a}_{2}} = \frac{{f}_{1}}{{f}_{2}}$ (2) on the focal distances and periods in FIG. 1. We further assume path-independent transmission coefficients *tᵢ* and note that a lateral displacement *D* of grating 2 introduces a phase in these coefficients, which take the path dependent values e^{∓2*π*i*D*/a₂}*t*₂.

In the configuration of FIG. 1, and without external illumination from the light source 7, the fraction of electrons transmitted through the on-axis beam reduces to ${P}_{0} \left(D\right) = 4 {\left|{t}_{1}{t}_{2}\right|}^{2} {cos}^{2} \left(2πD/{a}_{2}\right) ,$ (3) which displays an interference pattern as a function of *D,* cf. FIG. 2, the curve labeled "without illumination". The grating displacement *D* can be adjusted to compensate for any uncontrolled phase difference between the two paths. In the presence of illumination, the superposition of different inelastic channels in the post-interaction wave function [Equation (1a)] leads to a probability of on-axis transmission modified from Equation (3) to $P \left(D\right) = {P}_{0} \left(D\right) + 2 {\left|{t}_{1}{t}_{2}\right|}^{2} Re \left\{{e}^{\frac{4 π i D}{{a}_{2}}}\left({\sum }_{l} {α}_{A , l} {α}_{B , l}^{∗} - 1\right)\right\} ,$ (4) where the coefficients *tᵢ* are assumed to vary negligibly within the range of inelastic energy transfers under consideration, and we have used the property ∑_{ℓ} |*α_{n,ℓ}*|² = 1, i.e., the interaction with light does not change the total electron probability.

Taking path *B* of FIG. 1 sufficiently far away from the specimen S to neglect its interaction with light, we have *α_{B,ℓ}* = *δ*_{ℓ0} and consequently, Equation (4) becomes *P*(*D*) *= P*₀(*D*) *+* 2|*t*₁*t*₂|²cos(4*πD*/*a*₂)[*J*₀(2|β*_{A}*|) - 1]. We are interested in the difference produced in the electron current with and without illumination, i.e., SFES signal, see FIG. 2. One possibility would be to record this current as a function of the displacement *D.* A more convenient approach is adjusting *D,* i.e., by measuring the electron current without specimen to suppress the on-axis transmission when *D*/*a*₂ = 1/4 + *n*/2 for any integer *n.* Then, the SFES probability of transmitting an electron in the on-axis beam reduces to $P \left({D}_{0}\right) = 2 {\left|{t}_{1}{t}_{2}\right|}^{2} \left[1-{J}_{0}\left(2\left|{β}_{A}\right|\right)\right] \approx 2 {\left|{t}_{1}{t}_{2}\right|}^{2} {\left|{β}_{A}\right|}^{2} ,$ (5) where the rightmost approximation applies to small IELS coefficients |*β_{A}*| << 1.

We plot |*β_{A}*|²| in FIG. 3 for a configuration in which path *A* passes near a silver sphere featuring a dipolar mode, i.e., prominent broad peak, as well as higher-order resonances. The result is compared to EELS and angle-integrated cathodoluminescence (CL) spectra for an electron following a single path *A*. The SFES spectrum is similar to that obtained with CL, as expected from the fact that the light-electron coupling coefficient *β* and the CL emission amplitude **f** are related through the rigorous relation [12] *β* = i*c*²**f** · **E**^{ext}/(ℏ*ω*²), provided *β* refers to an electron moving along a trajectory **r₀** + **v***t* and external plane-wave illumination with field amplitude **E**^{ext} and wave vector **k** = *(ω*/*c*) **k̂**, while **f** corresponds to emission with wave vector **-k** produced by an electron moving along the trajectory **r**₀ - **v***t*. In contrast, EELS does not require far-field coupling, thus placing a comparatively higher weight on nondipolar modes.

The scheme illustrated in FIG. 1 and discussed with respect to FIGs. 1-3 would typically require angle-resolved electron detection to filter the on-axis transmitted e-beam, which might be challenging for the small diffraction angles typically produced by transmission electron gratings [13], e.g., first-order beams are transmitted with an angle *θ*₂ = ${sin}^{- 1} \left(\frac{2 πℏ}{{m}_{e} {a}_{2} v}\right)$, which is ≈ 17 prad for *a*₂ = 200 nm and 200 keV electrons.

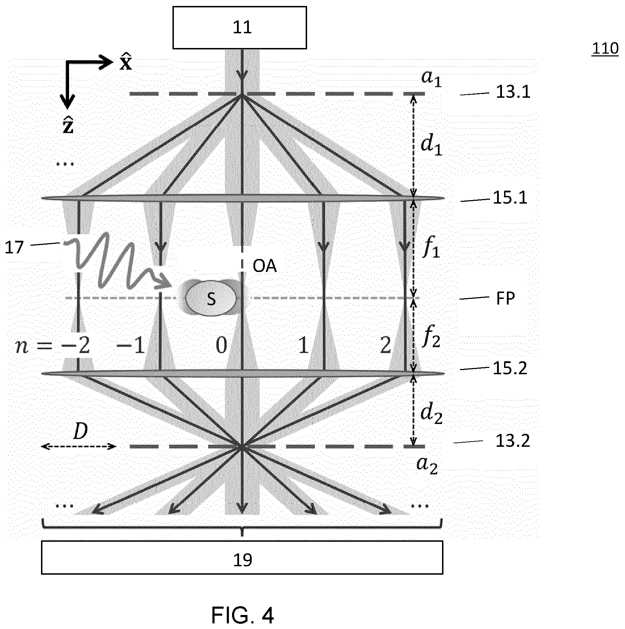

A more convenient configuration that eliminates the need for angular resolution is presented in FIG. 4, where all diffracted beams, i.e., all orders, are collected by the electron detector and grating coordination [Equation (2)] is still observed.

FIG. 4 illustrates a system 110 system for spectrally resolved electron microscopy according to a further embodiment of the present disclosure. The principle setup of the system 110 of FIG. 4 is similar to the setup of the system of FIG. 1, however, the system 110 of FIG. 4 provides SFES based on the detection of all diffracted beams as a single integrated signal. The system 110 of FIG. 4 involves an electron source 11 which may be similar to the electron source 1 of FIG. 1. Further, FIG. 11 illustrates that the electron beam emitted from the electron source 11 impinges on a first diffraction element 13.1. The first diffraction element 13.1 may be a first grating having a period of a₁. The first diffraction element 13.1 is configured to diffract the electron beam. The diffracted electron beam is then received by a first electron focusing element 15.1 having a focal length *f*₁. The distance between the first diffraction element 13.1 and the first electron focusing element is given by *d*₁*.* FIG. 4 further illustrates that the electron beams, diffracted by the first diffraction element 13.1 and focused by the first electron focusing element 15.1 are focused on a focal plane FP. FIG. 4 further illustrates a second electron focusing element 15.2 having a focal length *f*₂. The second electron focusing element 15.2 is configured to focus the electron beam received from the focal plane FP onto a second diffraction element 13.2, e.g., a second grating having a period *a*₂. Finally, FIG. 4 illustrates an electron detector 19 which is configured to collect, i.e., to measure the electron beam current received from the second diffraction element 13.2. It should be understood that the electron detector 19 may include one or more processors, e.g., computing elements for analyzing the measured data. In addition or alternatively, the electron detector 9 may be coupled with an external computer or the like for data analysis. Such analysis elements are well understood and are not further detailed here.

Similar to the system of FIG. 1, the system of FIG. 4 illustrates a light source 17 which provides at least partially coherent light. The light source 17 is configured to illuminate a specimen S when such a specimen is introduced into the system 110, in order to be probed.

For FIG. 4, we may further impose the condition $\frac{{f}_{1}^{2}}{{f}_{2}^{2}} = - \frac{{d}_{1} - {f}_{1}}{{d}_{2} - {f}_{2}} ,$ which should guarantee that each grating lies in the image plane of the other one through the two-lens system. Since the electron wavelength is small compared to the periods, we can describe the gratings through local periodic transmission functions *tⱼ*(*x*) *= tⱼ*(*x + aⱼ*), whose Fourier transform coefficients ${t}_{j , n} = {\int }_{- {a}_{j} / 2}^{{a}_{j} / 2} {dxt}_{j} \left(x\right) {e}^{- 2 π i nx / {a}_{2}}$ are the amplitudes of the diffracted beams. In the absence of a specimen, the transmission probability through the setup is given by ${P}_{0} \left(D\right) = {\int }_{- \frac{1}{2}}^{\frac{1}{2}} dθ {\left|{t}_{1}\left({θa}_{1}\right){t}_{2}\left(-{θa}_{2}-D\right)\right|}^{2} ,$ (6) which, as expected, corresponds to the superposition of the two gratings.

We are interested in suppressing electron transmission in the absence of a specimen, such that the SFES signal when introducing an illuminated specimen does not have to be extracted from a dark-count background. With black-and-white gratings, i.e., *tⱼ*(*x*) ∈ {0,1}, such as slit arrays, suppression is possible if the area occupied by the openings is half or less of the total grating surface area. For example, when the slit widths are half of the periods, e.g., *tⱼ*(*x*) *=* Θ(*aⱼ*/4 - *x*) in the first period, the probability becomes *P*₀(*D*) = 1/2 - |*D*|/*a*₂ for |*D*| < *a*₂/2, featuring a complete depletion of electron transmission if *D = a*₂/*2.* By making the slit openings narrower, Equation (6) predicts a complete suppression of transmission occurring over a finite range of *D* values, which should render SFES more tolerant to an imperfect lateral coherence of the e-beam.

When placing an illuminated specimen at the focal plane FP in the scheme of FIG. 4, the electron transmission probability becomes $P \left(D\right) = {\sum }_{n , l} {\left|{\sum }_{n ′} {α}_{n ′ , l} {t}_{1 , n ′} {t}_{2 , n ′ + n} {e}^{- i n ′ {g}_{2} D}\right|}^{2} ,$ (7) where we have introduced the IELS amplitudes *α*_{*n*',ℓ} defined in Equation (1b).

Different *n'* beams diffracted by grating 1 still interfere within each final electron energy subspace ℓ, while different n beams, after diffraction by grating 2, are summed incoherently. For simplicity, we consider that only the *n*' = 0 focused beam interacts with the optical field so that the rest of the beams have interaction coefficients *α*_{*n*'≠0,ℓ} = *δ*_{ℓ,0}. Further setting the grating configuration including *D* such that *P*₀ = 0, Equation (7) reduces to $P \left({D}_{0}\right) = 2 {\left|{t}_{10}\right|}^{2} {T}_{2} \left[1-{J}_{0}\left(2\left|{β}_{0}\right|\right)\right] ,$ (8) **where** *T*₂ = ∑*ₙ* | *t*_{2,*n*}|². For example, for slit-based gratings with slit widths *aⱼ*/2*,* we have |*t*₁₀|² = 1/4 and *F*₂ = 1/2, and considering a coupling coefficient |*β*₀| << 1, the probability becomes *P* ≈ |*β*₀|²/4.

In a feasible implementation, grating periods *aⱼ* of 100's of nm have been fabricated [13], while *fⱼ* and *dⱼ* can be in the millimeter range, thus rendering a linear periodic array of foci with a period *g*₁*f*₁/*q*₀ of 10's of nm.

For the embodiment of FIG. 4 as well as for the embodiment of FIG. 1, the following holds. A specimen S to be studied is placed with illumination by a light source in the region between the two electron-focusing elements, e.g. lenses. Thereby, the condition of electron depletion is broken and an electron signal is collected by the electron detector as a function of specimen position, i.e. coordinates *x, y, z*, and illumination frequency of the light used to illuminate the specimen.

Using the measurement of the electron detector, i.e. 9, 19, spectra can be constructed by plotting the electron signal as a function of light frequency. Thereafter, an image can be retrieved by computationally reconstructing it from the electron signal as a function of specimen position (*x,y,z*) in a sufficiently fine grid. This can be done for each frequency separately, or combining information from different frequencies.

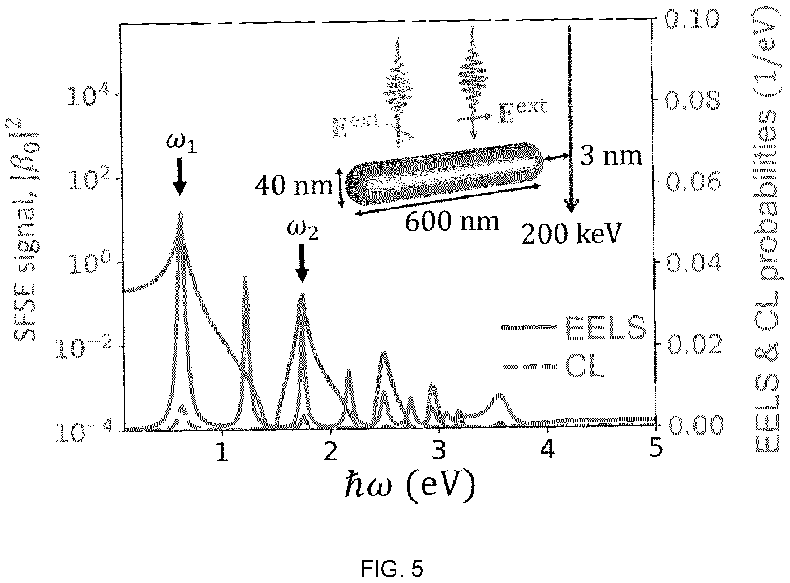

For illustration, and taking into account the scheme discussed with respect to FIG. 4, FIG. 5 shows the mapping of plasmons in a long silver nanowire via SFES.

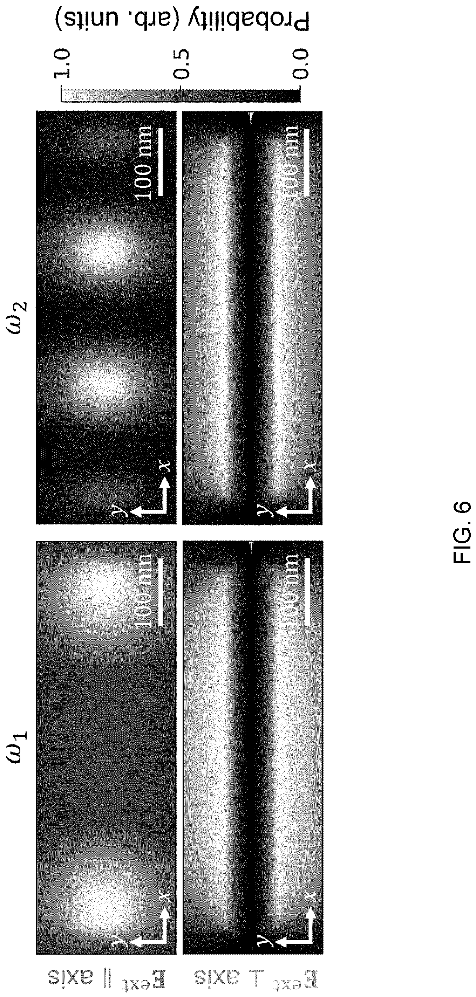

FIG. 5 illustrates SFES mapping of localized optical excitations. FIG. 5 shows a comparison of EELS and CL spectra with the electron-light coupling probability |*β*₀|² in SFES for a silver nanowire under the geometry depicted in the inset. In SFES, we consider illumination with an intensity of 1 MV/m and polarization parallel to the nanowire axis. FIG. 6 illustrates how SFES maps the optical response of the nanowire as a function of e-beam position for illumination either parallel (top) or perpendicular (bottom) to the nanowire axis and light frequencies tuned to the frequencies *ω*₁ and *ω*₂ of the dipolar and quadrupolar modes of the particle.

Like in the sphere of FIG. 3, the SFES spectrum, where we plot |*β*₀|², yields similar information as EELS, cf. FIG. 5. However, the near-field enhancement is larger in the nanowire, thus producing stronger IELS coupling for a given incident light intensity. By raster scanning the central beam and tuning the light frequencies to the first dipole-active modes, we observe the characteristic maps shown in the top panels of FIG. 6. Like EEGS, SFES allows us to select the external light polarization, which shows that these modes are polarized along the wire by comparison to the featureless maps obtained under transverse polarization (bottom panels).

In summary, our proposed scheme can yield spectrally and spatially resolved information by measuring the transmitted free-electron current without needing either electron spectrometers or angle-resolved detection. A spectral resolution in the (sub-)µeV range should be attainable with nanosecond laser pulses illuminating the sample in combination with electron pulses of similar duration using already developed EEGS setups [12]. This level of temporal precision can be achieved through synchronized electron blanking like in EEGS [12] either using electrostatic e-beam deflection of the recently developed microwave cavity electron pulsing [14]. This method is compatible with the use of spectrally broad e-beams, whose temporal coherence becomes irrelevant. Additionally, only a moderate level of e-beam collimation is required, so that the lateral coherence length of the incident electrons lies in the micron range, covering a sufficient number of grating periods to produce well-defined diffracted spots. By imaging each grating on each other, the condition of total e-beam depletion in the absence of an illuminated specimen is robust, e.g., tolerant to small grating misalignments and e-beam quality, and therefore, the SFES signal does not have to be extracted from a strong background current. The SFES signal relies on stimulated IELS, and thus, it can be modulated by playing with the light intensity, in contrast to spontaneous processes in EELS and CL. In addition, optical phase information could be obtained through homodyne detection by additional exposure of the e-beam to optical near fields before interaction with the specimen. Elastic scattering by the specimen and spontaneous inelastic scattering can affect the condition of electron depletion for thick samples, which should require further analysis for the extraction of near-field information from SFES. As an extension of the proposed scheme, conjugated masks with more general patterns could be used instead of gratings to, for example, prepare vortex beams [15] by still imposing the condition of e-beam depletion in the absence of a specimen. The interaction of multiple beams with illuminated regions of the specimen could also be conceived, which would require data analysis to resolve the contribution of the near field at each individual focal spot.

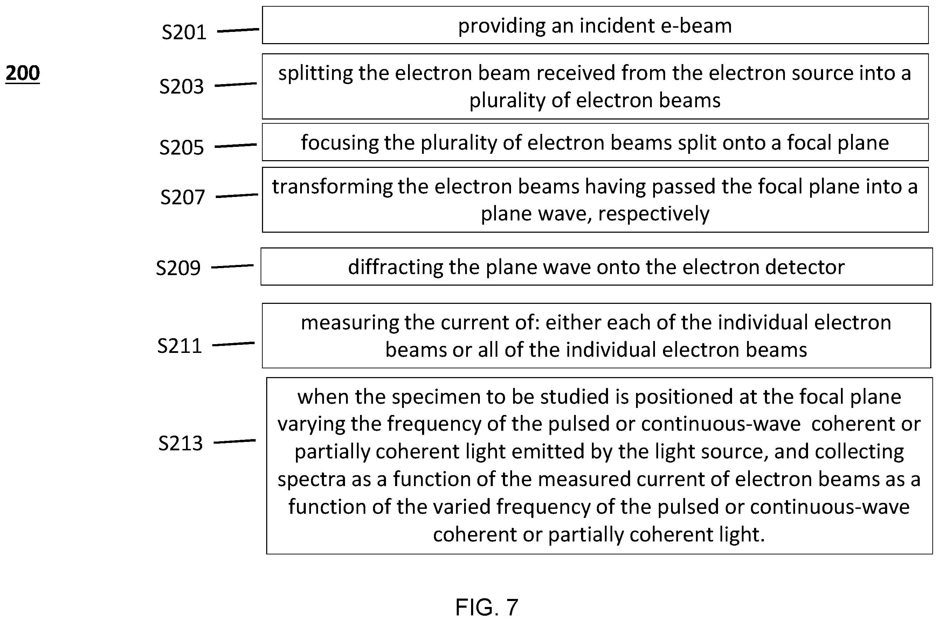

The present disclosure further provides a second aspect of a method 200 for performing spectrally resolved electron microscopy with a system according to the embodiment of FIG. 4 or the embodiment of FIG. 1. This method is schematically indicated in FIG. 7. The method 200 of FIG. 7 comprises the following steps: providing, S201, by the electron source, an incident e-beam; splitting, S203, by the first diffraction element, the electron beam received from the electron source into a plurality of electron beams; focusing, S205, by the first electron focusing element, the plurality of electron beams split by the first diffraction element, onto a focal plane; transforming, S207, by the second electron focusing element, the electron beams received from the focal plane into a plane wave, respectively; diffracting, S209, by the second diffraction element, the plane wave received from the second electron focusing element onto the electron detector; measuring, S211, by the electron detector, the current of: either each of the individual electron beams received from the second diffraction element by using angular resolution in the electron detector or all of the electron beams received from the second diffraction element by using an angle-integrated electron detector; and when the specimen to be studied is positioned at the focal plane between the first electron focusing element and the second electron focusing element, varying, S213, the frequency of the pulsed or continuous-wave coherent or partially coherent light emitted by the light source to illuminate the specimen, and collecting, by the electron detector, spectra as a function of the measured current of electron beams as a function of the varied frequency of the pulsed or continuous-wave coherent or partially coherent light.

This work was supported by European Research Council (Grant No. 101141220-QUEFES).

### References

[1] E. Ruska, Rev. Mod. Phys. 59, 627 (1987).
[2] D. A. Muller, L. Fitting Kourkoutis, M. Murfitt, J. H. Song, H. Y. Hwang, J. Silcox, N. Dellby, and O. L. Krivanek, Science 319, 1073 (2008).
[3] F. S. Hage, G. Radtke, D. M. Kepaptsoglou, M. Lazzeri, and Q. M. Ramasse, Science 367, 1124 (2020).
[4] J. Zhou, P. A. D. Gonçalves, F. Riminucci, S. Dhuey, E. S. Barnard, A. M. Schwartzberg, F. J. Garcia de Abajo, and A. Weber-Bargioni, Nat. Commun. 15, 9583 (2024).
[5] F. J. Garcia de Abajo and M. Kociak, New J. Phys. 10, 073035 (2008).
[6] Y. Auad, E. J. C. Dias, M. Tencé, J.-D. Blazit, X. Li, L. F. Zagone, O. Stéphan, L. H. G. Tizei, F. J. Garcia de Abajo, and M. Kociak, Nat. Commun. 14, 4442 (2023).
[7] B. Barwick, D. J. Flannigan, and A. H. Zewail, Nature 462, 902 (2009).
[8] F. J. Garcia de Abajo, A. Asenjo-Garcia, and M. Kociak, Nano Lett. 10, 1859 (2010).
[9] A. Feist, K. E. Echternkamp, J. Schauss, S. V. Yalunin, S. Schäfer, and C. Ropers, Nature 521, 200 (2015).
[10] L. Piazza, T. T. A. Lummen, E. Quiñonez, Y. Murooka, B. Reed, B. Barwick, and F. Carbone, Nat. Commun. 6, 6407 (2015).
[11] K. Wang, R. Dahan, M. Shentcis, Y. Kauffmann, A. Ben Hayun, O. Reinhardt, S. Tsesses, and I. Kaminer, Nature 582, 50 (2020).
[12] F. J. Garcia de Abajo and V. Di Giulio, ACS Photonics 8, 945 (2021).
[13] C. W. Johnson, A. E. Turner, F. J. Garcia de Abajo, and B. J. McMorran, Phys. Rev. Lett. 128, 147401 (2022).
[14] T. C. H. de Raadt, J. G. H. Franssen, and O. J. Luiten, Phys. Rev. Lett. 130, 205001 (2023).
[15] J. Verbeeck, H. Tian, and P. Schattschneider, Nature 467, 301 (2010).

### List of reference signs

- 100, 110: system
- 1, 11: electron source
- 3.1, 13.1: first diffraction element
- 3.2, 13.2: second diffraction element
- 5.1, 15.1: first electron focusing element
- 5.2, 15.2: second electron focusing element
- *a*₁: period of first diffraction element
- *a*₂: period of second diffraction element
- *f*₁: focal length of first electron focusing element
- *f*₂: focal length of second electron focusing element
- *d*₁: distance between first diffraction element and first electron focusing element
- *d*₂: distance between second diffraction element and second electron focusing element
- OA: optical axis
- 7, 17: light source
- FP: focal plane
- S: specimen
- 9, 19: electron detector
- *A*: path of
- *B*: path of
- *D*: relative parallel shift of first diffraction element with respect to second diffraction element

## Claims

1. A system (100,110) for spectrally resolved electron microscopy, comprising
an electron source (1, 11) configured to provide an incident electron beam;
a pair of diffraction elements (3.1, 3.2, 13.1, 13.2), including a first diffraction element (3.1, 13.1) and a second diffraction element (3.2, 13.2), each diffraction element suitable for diffracting electron beams;
a pair of electron-focusing elements (5.1, 5.2, 15.1, 15.1) including a first electron-focusing element (5.1, 15.1) with a focal length of *f*₁, and a second electron-focusing element (5.2, 15.2) with a focal length of *f*₂;
a light source (7, 17) configured to provide pulsed or continuous wave coherent or partially coherent light in order to illuminate a specimen (S) to be studied positioned between the first electron focusing element (5.1, 15.1) and the second electron focusing element (5.2, 15.2) ;
an electron detector (9, 19);
wherein the first diffraction element (3.1, 13.1) is configured to split the electron beam received from the electron source (1, 11) into a plurality of electron beams;
wherein the first electron focusing element (5.1, 15.1) is configured to focus the electron beams transmitted by the first diffraction element (3.1, 13.1) onto a focal plane (FP);
wherein the second electron focusing element (5.2, 15.2) is configured to transform the electron beams transmitted by the first electron-focusing element and having passed the focal plane (FP) into one plane wave each, respectively;
wherein the second diffraction element (3.2, 13.2) is configured to diffract the plane wave received from the second electron-focusing element (5.2, 15.2) onto the electron detector (9, 19);
wherein the light source (7, 17) is configured to vary the frequency of the pulsed or continuous-wave coherent or partially coherent light, and the electron detector (9, 19) is configured to measure the current of the electron beams received from the second diffraction element (3.2, 13.2) and to collect spectra formed by the measured current as a function of the varied frequency of the pulsed or continuous-wave and at least partially coherent light.

2. The system (100, 110) according to claim 1, wherein the second diffractive element (3.2, 13.2) is laterally adjustable with respect to the first diffractive element (3.1, 13.1).

3. The system (100, 110) according to claim 1 or 2, wherein the first diffraction element (3.1, 13.1) and the second diffraction element are laterally positioned complementary to each other such that in absence of the specimen (S) electron beams transmitted by the first diffraction element and having passed the first focusing element (5.1, 15.1) and the second focusing element (5.2, 15.2) are blocked by the second diffraction element (3.2, 13.2).

4. The system (100, 110) according to any one of claims 1 to 3, wherein the first diffractive element (3.1, 13.1) is a first electron grating with a period of *a*₁, and a second diffractive element (3.2, 13.2) is a second electron grating with a period of *a*₂, where the periods *a*₁, *a*₂ and the focal lengths *f*₁ and *f*₂ fulfil the condition $\frac{{a}_{1}}{{a}_{2}} = \frac{{f}_{1}}{{f}_{2}} .$

5. The system (100, 110) according to any one of claims 1 to 3, wherein the first diffractive element (3.1, 13.1) and the second diffractive element (3.2, 13.2) represent conjugated electron masks configured to prepare beams with predefined transverse symmetries, such as vortices.

6. The system (100, 110) according to any one of claims 1 to 5, wherein a distance between the first electron focusing element (5.1, 15.1) and the focal plane (FP) is equal to the distance between the first diffractive element (3.1, 13.1) and the first electron focusing element (5.1, 15.1), and a distance between the second electron focusing element (5.2, 15.2) and the focal plane (FP) is equal to the distance between the second diffractive element (3.2, 13.2) and the second electron focusing element (5.2, 15.2).

7. The system (110) according to any one of claims 1 to 6, wherein the electron detector (9, 19) is configured to collect all diffracted beams received from the second diffractive element (3.2, 13.2).

8. The system (110) according to any one of claims 1 to 7, wherein the first diffractive element (3.1, 13.1), the first electron focusing element (5.1, 15.1), the second electron focusing element (5.2, 15.2), and the second diffractive element (3.2, 13.2) are arranged such that the first diffractive element (3.1, 13.1) is imaged onto the second diffractive element (3.2, 13.2) and vice versa.

9. The system (100) according to any one of claims 1 to 6, wherein the electron detector (9) is configured to provide angle-resolved electron detection.

10. The system (100) according to claim 9, wherein the first and the second diffractive elements (3.1, 3.2) are symmetric diffractive elements and are configured to transmit only the first two diffraction orders of the electron beam incident on the respective diffractive element, wherein the second diffractive element (3.2) is configured to recombine different electron beams that were focused in the focal plane (FP).

11. The system (100, 110) according to any one of the preceding claims, wherein the system (100, 110) is configured to raster scan the central beam of the electron beam emitted by the second diffractive element (3.2, 13.2) and to tune the light source (7, 17) to dipole active modes, in order to map the specimen (S).

12. The system (100, 110) according to any one of the preceding claims, wherein:
when the specimen (S) is positioned between the first electron-focusing element (5.1, 15.1) and the second electron-focusing element (5.2, 15.2) and is illuminated by the light source, the system (100, 110) is configured to
detect the interaction of one or more of the focused beams transmitted by the first diffractive element (3.1, 13.1) with the illuminated specimen (S); and
when no specimen is positioned in the system (100, 110), the electron detector (9, 19) is configured to detect a partial or complete depletion of the electron beam transmitted by the second diffractive element (3.2, 13.2).

13. A method for performing spectrally resolved electron microscopy with a system (100, 110) according to any one of claims 1 to 12, the method comprising:
providing (S201), by the electron source (1, 11), an incident e-beam;
splitting (S203), by the first diffraction element (3.1, 13.1), the electron beam received from the electron source (1, 11) into a plurality of electron beams;
focusing (S205), by the first electron focusing element (5.1, 15.1), the plurality of electron beams split by the first diffraction element (3.1, 13.1), onto a focal plane;
transforming (S207), by the second electron focusing element (5.2, 15.2), the electron beams transmitted by the first electron-focusing element and having passed the focal plane into a plane wave, respectively;
diffracting (S209), by the second diffraction element (3.2, 13.2), the plane wave received from the second electron focusing element (5.2, 15.2) onto the electron detector (9, 19);
measuring (S211), by the electron detector (9, 19), the current of: either each of the individual electron beams received from the second diffraction element (3.2, 13.2) by using angular resolution in the electron detector (9, 19) or all of the electron beams received from the second diffraction element (3.2, 13.2) by using an angle-integrated electron detector; and
when the specimen to be studied is positioned between the first electron focusing element (5.1, 15.1) and the second electron focusing element (5.2, 15.2), varying (S213) the frequency of the pulsed or continuous-wave coherent or partially coherent light emitted by the light source to illuminate the specimen, and collecting, by the electron detector, spectra as a function of the measured current of electron beams as a function of the varied frequency of the pulsed or continuous-wave coherent or partially coherent light.

14. The system (100, 110) according to claim 13, further comprising: laterally adjusting the first diffraction element (3.1, 13.1) and the second diffraction element complementary to each other such that in absence of the specimen (S) electron beams transmitted by the first diffraction element and having passed the first focusing element (5.1, 15.1) and the second focusing element (5.2, 15.2) are blocked by the second diffraction element (3.2, 13.2).
